# EUROPEAN PATENT APPLICATION

(11) **EP 4 340 034 A1**
(43) Date of publication of application: **20.03.2024**
(21) Application number: 22195896.0
(22) Date of filing: 15.09.2022
(51) Int. Cl.: H01L 29/06, H01L 21/329, H01L 29/872

(54) **MPS DIODE HAVING A NON-UNIFORMLY DOPED REGION AND METHOD FOR MANUFACTURING THE SAME**

(71) Applicant: Nexperia B.V., 6534 AB Nijmegen (NL)
(72) Inventor: Mazzillo, Massimo Cataldo, 6534AB Nijmegen (NL)
(74) Representative: Pjanovic, Ilija

(57) **Abstract**

Aspects of the present disclosure generally relate to an MPS diode and a manufacturing method therefor. The MPS diode comprises a semiconductor body including an active area, wherein the active area comprises a drift region of a first conductivity type, and a plurality of wells of a second conductivity type different from the first conductivity type, the plurality of wells being mutually spaced apart, each well forming a respective PN-junction with the drift region. The MPS diode further comprises a metal layer assembly arranged on a surface of the semiconductor body and comprising at least one metal layer, the metal layer assembly forming a plurality of Schottky contacts together with the drift region and a plurality of respective Ohmic contacts with the plurality of wells. The drift region comprises a doped region surrounding each of the plurality of wells, the doped region having a higher dopant concentration than a remainder of the drift region. The dopant concentration in the doped region decreases in a first direction from a center of the doped region to an edge of the doped region.

## Description

### FIELD

Aspects of the present disclosure generally relate to an MPS diode. Aspects of the present disclosure further relate to a method for manufacturing such MPS diodes.

### BACKGROUND

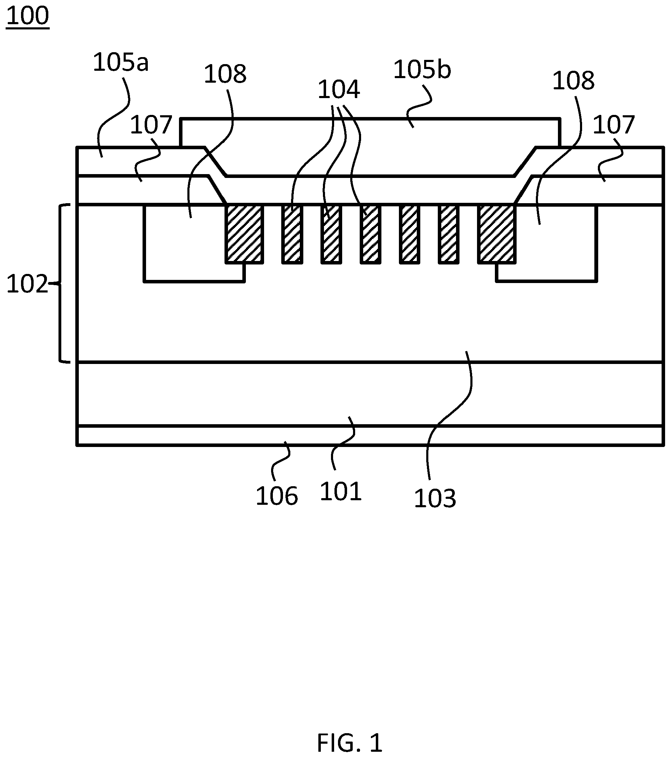

A cross-sectional view of a typical Merged-PiN Schottky (MPS) diode 100 known in the art is shown in FIG. 1. MPS diode 100 comprises a substrate 101 and an epitaxial layer 102 arranged on said substrate 101, which together form a semiconductor body. Epitaxial layer 102 comprises a drift region 103 and a plurality of wells 104. Drift region 103 is of a first conductivity type, i.e., drift region 103 has one of an n-type doping and p-type doping. Wells 104 are of a second conductivity type different from the first conductivity type, i.e., an opposite conductivity type to drift region 103.

MPS diode 100 further comprises a metal layer assembly arranged on the semiconductor body. In this example, the metal layer assembly comprises a first metal layer 105a that is brought into contact with drift region 103 and wells 104. First metal layer 105a forms a plurality of Schottky contacts with drift region 103, and a plurality of Ohmic contacts with wells 104. Metal layer assembly may include a second metal layer 105b which is arranged on first metal layer 105a and may form a first terminal of MPS diode 100 that provides external electrical access thereto. Furthermore, a contact 106 is arranged on substrate 101 and may form a second terminal of MPS diode 100 that provides external electrical access thereto.

Wells 104 and drift region 103 are included in an active area of the semiconductor body. A termination area 108 may be provided adjacent to the active area that can accommodate a high electric field to prevent premature breakdown from occurring along an edge or periphery of the active area. The metal layer assembly may be electrically insulated from the termination area, for example by an insulating layer 107 such as an oxide layer. Further layers not shown in FIG. 1 may be arranged, such as passivation layers, as appreciated by the skilled person.

Wells 104 form respective PN junctions with drift region 103. Depending on a forward voltage applied to the first and second terminal, MPS diode 100 may be operable in several modes. At lower voltages, MPS diode 100 may operate in a first mode, a depletion region of said PN junctions extends between adjacent wells, thereby preventing or substantially limiting a Schottky current from flowing from first metal layer 105a towards substrate 101. At higher voltages, MPS diode 100 may operate in a second mode, in which the depletion region of said PN junctions becomes smaller, thereby enabling a Schottky current to flow from first metal layer 105a towards substrate 101.

Key parameters of MPS diodes include an on-state voltage drop *V_{F}* and forward surge current capability *IFSM.* These two parameters are particularly relevant for the power dissipation and power handling capability of the MPS diode. There is a need for MPS diodes having a relatively low on-state voltage drop *V_{F}* and improved forward surge current capability *IFSM.*

### SUMMARY

Aspects of the present disclosure relate to an MPS diode in which the abovementioned drawback(s) do not occur, or hardly so.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, an MPS diode is provided. The MPS diode comprises a semiconductor body including an active area, wherein the active area comprises a drift region of a first conductivity type, and a plurality of wells of a second conductivity type different from the first conductivity type, the plurality of wells being mutually spaced apart, each well forming a respective PN-junction with the drift region. The MPS diode further comprises a metal layer assembly arranged on a surface of the semiconductor body and comprising at least one metal layer, the metal layer assembly forming a plurality of Schottky contacts together with the drift region and a plurality of respective Ohmic contacts with the plurality of wells. The drift region comprises a doped region surrounding each of the plurality of wells, the doped region having a higher dopant concentration than a remainder of the drift region, wherein, in a first direction from a center of the doped region to an edge of the doped region, the dopant concentration in the doped region decreases.

The Applicant has found that a current density closer to the edge of the active area is typically lower than in a center of the active area in known MPS diodes. This effect can negatively impact the on-state voltage *V_{F}* and/or the forward surge current capability *IFSM* due to a smaller portion of the active area participating to the current conduction of the MPS diode. Moreover, in some regions of the device can be prematurely subjected to conduction of high current density resulting in local heating effects which can be detrimental for long-term operation of the MPS diode.

In particular, it was found that a voltage drop across the PN junctions is higher in the center of the active area due to a contribution of current generated near the edge of the active area. Said current not only flows downwards towards the substrate, but also flows partially laterally towards the center of the active area. As a result, a higher voltage drop is generated along a longer path, causing PN junctions near the edge of the active area to have a lower voltage drop than PN junctions near the center of the active area. This, in turn, causes the space between adjacent wells near the edge of the active area to be relatively more depleted, thus limiting the Schottky current more at the edge of the active area.

It was found that by introducing the doped region of which the dopant concentration decreases from the center to the edge thereof in accordance with the present disclosure, the voltage drop near the edge of the active area can be increased, thereby improving the current uniformity in the active area. This can in turn improve the on-state voltage *V_{F}* and the forward surge current capability *IFSM.*

The doped region may comprise a substantially uniformly doped center region and a substantially uniformly doped outer region arranged in between the center region and the edge of the doped region. The center region may have a higher dopant concentration than the outer region.

The doped region may comprise a plurality of said outer regions. Outer regions arranged closer to the center region may have a higher dopant concentration than outer regions arranged further from the center region. In a further embodiment, the plurality of outer regions may have a substantially identical width in the first direction, though this does not need to be the case.

The center region may surround between 40-60% of the number of wells, preferably about 50%, and the outer region(s) may surround a remainder of the number of wells.

Such center region and outer region(s) can be formed using one or more implant steps and can be formed efficiently during the manufacturing process. They can be formed as nested wells, or simply as adjacent wells, for example using respective masking layer(s).

A dopant concentration in the center region may be at least two times higher than a dopant concentration at or near the edge of the doped region, preferably at least three times higher.

A dopant concentration in the doped region may be at least two times greater than a dopant concentration in a remainder of the drift region. Within the context of the present disclosure, the remainder of the drift region may correspond to a region at least extending between the substrate and the doped region, for example a portion of the epitaxial layer through which the Schottky current flows during normal operation.

The doped region and the plurality of wells may each extend from the surface of the semiconductor body. Furthermore, the doped region may extend further into the semiconductor body than the plurality of wells, preferably at least 10% further, more preferably at least 20% further. By extending the doped region to a depth lower than the plurality of wells, the lateral current component is further limited and current uniformity across the active area can be further improved.

The plurality of wells may be arranged as parallel strips or as concentric shapes, such as elliptical or polygonal shapes. For example, the MPS diode may have a radially symmetric structure viewed from above, that is, in a direction from the epitaxial layer to the substrate.

A spacing between adjacently arranged wells among the plurality of wells may be substantially identical. Alternatively, the wells of each pair of adjacently arranged wells may be relatively spaced apart such that the doped region between said wells becomes depleted at substantially a same voltage applied to the MPS diode. In other words, a spacing between adjacent wells may be selected such that a pinch-off voltage for each pair of wells is roughly the same.

For example, the wells of each pair of adjacently arranged wells may have a spacing that increases from the center of the doped region to the edge of the doped region, in accordance with the dopant concentration of the doped region in between said wells.

The MPS diode may typically be used as a rectifier. In that case, for example, the MPS diode may need to conduct a relatively high current in its forward mode of operation and should block or substantially limit current from flowing in reverse bias. In reverse conditions, current leakage may occur if some of the pairs of wells are not substantially pinched off. Hence, by employing the above method, a leakage current in reverse bias operation can be limited.

The semiconductor body may further comprises a termination area arranged adjacent to the active area. The termination area may comprise means for preventing premature breakdown along a periphery of the active area, for example in reverse bias, by providing a structure in and/or on the semiconductor body that can accommodate a relatively high electric field, as will be appreciated by the skilled person.

The semiconductor body may comprise a substrate and an epitaxial layer arranged on said substrate,. The active area and, if applicable, the termination area may be arranged in the epitaxial layer.

The metal layer assembly may form a first terminal of the MPS diode. The MPS diode may further comprise a contact arranged on the substrate, said contact forming a second terminal of the MPS diode.

Each of the plurality of wells may further comprise a subregion having a higher dopant concentration than a remainder of said well for enabling an Ohmic contact with the metal layer assembly.

According to another aspect of the present disclosure, a method for manufacturing an MPS diode is provided. The method comprises providing a semiconductor body comprising a drift region of a first conductivity type, forming a doped region in the drift region, said doped region having a higher dopant concentration than a remainder of the drift region, wherein, in a first direction from a center of the doped region to an edge of the doped region, the dopant concentration in the doped region decreases, forming a plurality of wells of a second conductivity type different from the first conductivity type in the doped region, the plurality of wells being mutually spaced apart, each well forming a respective PN-junction with the drift region, and arranging a metal layer assembly on a surface of the semiconductor body, said metal layer assembly comprising at least one metal layer, wherein said metal layer assembly forms a plurality of Schottky contacts together with the drift region and a plurality of respective Ohmic contacts with the plurality of wells. The drift region comprises a doped region surrounding each of the plurality of wells, the doped region having a higher dopant concentration than a remainder of the drift region, wherein, in a first direction from a center of the doped region to an edge of the doped region, the dopant concentration in the doped region decreases.

### DESCRIPTION OF THE DRAWINGS

Next, the present disclosure will be described in more detail with reference to the appended drawings, wherein:
FIG. 1 is a cross-sectional view of a known MPS diode;
FIG. 2A is a cross-sectional view of an MPS diode in accordance with an embodiment of the present disclosure;
FIG. 2B is a graph illustrating a dopant concentration versus distance in the doped region of the MPS diode of FIG. 2A; and
FIGs. 3-5 are simplified top views illustrating configurations of the wells and the doped region in accordance with various embodiments of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

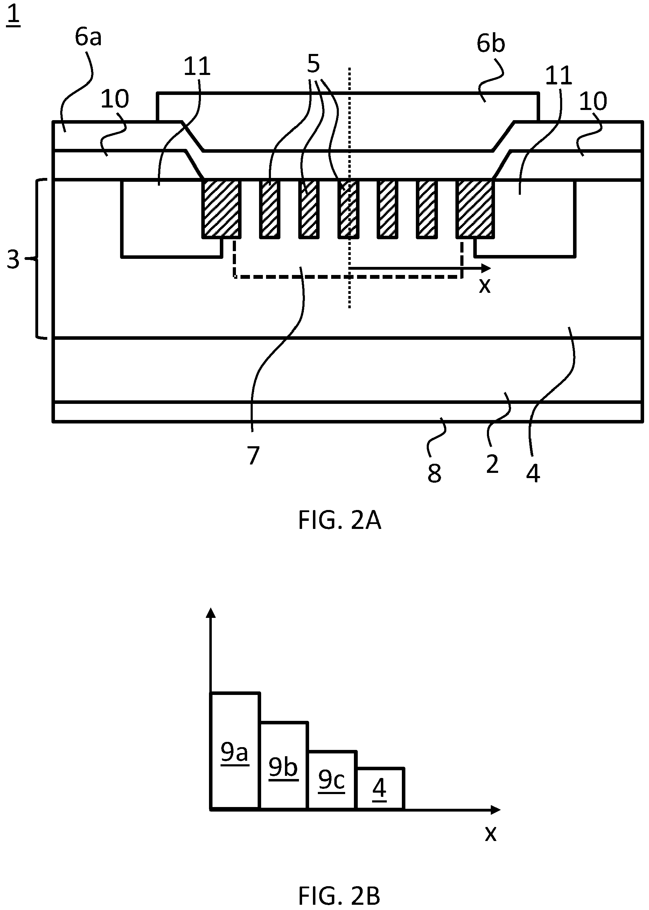

In FIG. 2A, a cross-sectional view of an MPS diode 1 is shown in accordance with an embodiment of the present disclosure. MPS diode 1 comprises a substrate 2 having an epitaxial layer 3 formed (e.g., grown) thereon which are included in the semiconductor body of MPS diode 1. Epitaxial layer includes a drift region 4 of a first conductivity type and a plurality of wells 5 of a second conductivity type which form part of an active area of MPS diode 1. Substrate 2 may have a same conductivity type as drift region 4 and typically has a substantially greater dopant concentration than drift region 4. Within the context of the present disclosure, the first conductivity type may correspond to one of an n-type and p-type doping, whereas the second conductivity type may correspond to another of an n-type and p-type doping.

Although not shown in FIG. 2A, the semiconductor body may further comprise a buffer layer in between substrate 2 and epitaxial layer 3, and typically having a dopant concentration in between that of substrate 2 and epitaxial layer 3.

A metal layer assembly is arranged on top of the semiconductor body, comprising a first metal layer 6a and, optionally, a second metal layer 6b. Furthermore, a contact 8 is arranged at a surface of substrate 2 opposite to epitaxial layer 3. The metal layer assembly and contact 8 may form respective terminals of MPS diode 1 that enable external electrical access to the semiconductor body.

First metal layer 6a is arranged to contact the drift region and the plurality of wells. In particular, first metal layer 6a forms a plurality of Ohmic contacts with wells 5, and a plurality of Schottky contacts with drift region 4 in between wells 5. To that end, first metal layer 6a may be made of a material or composite material that is suitable for forming said Schottky contacts and Ohmic contacts. Examples of such materials or composites include titanium or titanium nitride for forming the Schottky contacts and a nickel silicide for forming the Ohmic contacts, though the present disclosure is not limited thereto.

In some embodiments, a subregion (not shown) can be formed inside wells 5 at the surface of the semiconductor body for the purpose of improving the Ohmic contact with the metal layer assembly. For example, the subregion may comprise a highly doped region having a higher dopant concentration than a remainder of the well 5. A typical dopant concentration for wells 5 may for example be 1e18 cm⁻³, and a dopant concentration of the subregion may be 1e19 cm⁻³ or even 1e20 cm⁻³.

Second metal layer 6b is a top layer of the metal layer assembly in the embodiment shown in FIG. 2A and may thus form an outside contact of MPS diode 1 for external electrical access to first metal layer 6a. Second metal layer 6b may for example be made of aluminum, copper, alloys thereof, or the like, though the present disclosure is not limited thereto. Although two metal layers are shown in FIG. 2A, the present disclosure also envisages only having first metal layer 6a, or more than two metal layers which may be composed of the same or different materials with respect to first metal layer 6a and second metal layer 6b.

Contact 8 may form another outside contact of MPS diode 1, and may for example be made of titanium, nickel, silver, alloys thereof, or the like. Although one layer is shown in FIG. 2A, in some embodiments, contact 8 may comprise a plurality of layers, i.e., a metal layer stack. For example, contact 8 may comprise a first layer in contact with substrate 2 comprising a nickel silicon alloy, and a second layer in contact with the first layer that comprises titanium, nickel, silver, alloys thereof, or the like.

In drift region 4, a doped region 7 is provided surrounding each of the plurality of wells 5. Doped region 7 extends from a same surface of the semiconductor body as wells 5 and may for example extend at least 10% further into the semiconductor body than wells 5. Furthermore, doped region 7 is of the first conductivity type and may thus form a PN junction with each of the plurality of wells 5.

Doped region 7 has a dopant concentration that is greater than that of a remainder of drift region 4. Furthermore, doped region 7 has a lateral dopant profile of which the dopant concentration decreases from a center of doped region 7, indicated with a dashed line in FIG. 2A, to an edge of doped region 7, for example in a direction x indicated in FIG. 2A. By employing doped region 4 with the dopant profile, the current uniformity of MPS diode 1 can be improved.

In FIG. 2B, an exemplary dopant profile of doped region 7 is shown, from the center of doped region 4 in direction x and along the arrow in FIG. 2A. It is noted that doped region 7 may be symmetrical with respect to the center thereof for the purpose of improving current uniformity.

In this embodiment, doped region 7 comprises a center region 9a, a first outer region 9b and a second outer region 9c, each of which are substantially uniformly doped. Although two outer regions are shown in FIG. 2B, the present disclosure also envisages having only one outer region (e.g., first outer region 9b) or having more than two outer regions.

Here, it is noted that the present disclosure is not limited to substantially uniformly doped regions in doped region 7. As an example, center region 9a may be substantially uniformly doped, whereas one or both of first outer region 9b and second outer region 9c may have a continuously decreasing gradient in dopant concentration. Alternatively, center region 9a may also have a continuously decreasing dopant concentration gradient from the center of doped region 7 towards the edge thereof.

As an example only, drift region 4 may have a dopant concentration of about 1e16 cm⁻³, and doped region 7 may have a dopant concentration in a range between 1e16 -7e16 cm⁻³. For example, center region 9a may have a dopant concentration in a range between 6e16 - 7e16 cm⁻³, first outer region 9b may have a dopant concentration in a range between 4e16 - 5e16 cm⁻³, and second outer region 9c may have a dopant concentration in a range between 2e16 - 3e16 cm⁻³.

During manufacturing, doped region 7 may be formed in a single implant step, for example with a mask layer having a variable thickness to ensure the lateral dopant profile, or may be formed using multiple implant steps. In the latter case, for example, doped wells may be formed adjacent to one another to form, for example, center region 9a and outer regions 9b, 9c. Alternatively, the doped wells may be nested, for example by arranging second outer region 9c to surround first outer region 9b and by arranging first outer region 9b to surround center region 9a.

Referring again to FIG. 2A, MPS diode 1 may further include a termination area adjacent to the active area and in which a termination region 11 of the second conductivity type is arranged. The termination area may be configured to accommodate a relatively high electric field to prevent or limit breakdown from occurring in MPS diode 1 along an edge of the active area. Termination region 11 may be electrically insulated from the metal layer assembly by an insulating layer 10 such as an oxide layer. Doped region 7 may be spaced apart from the termination area, and in particular from termination region 11, though it may also extend across a full area of the active area. Termination region 11 may be formed to have a closed-loop shape surrounding the active region in the semiconductor body. Termination region 11 may for example have a dopant concentration in a range between 1e17 cm⁻³ - 1e18 cm⁻³.

Although the termination area in FIG. 2A is shown to include only a single termination region 11, a plurality of termination regions may be used. Various types of termination structures may be used in the termination area instead of the structure shown in FIG. 2A, as would be appreciated by the skilled person. For example, instead of a single zone junction termination extension (JTE), a double zone JTE may be used, guard rings at a floating potential, or the like. The present disclosure is not limited to any particular type of termination structure in the termination area.

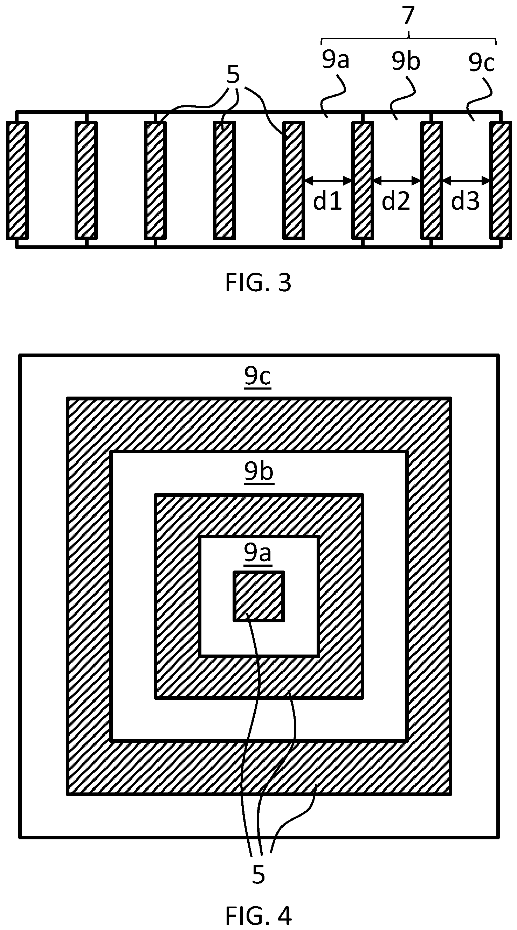

In FIG. 3, a simplified partial top view of MPS diode 1 of FIG. 2A in accordance with an embodiment of the present disclosure is shown. In particular, for convenience, only wells 5 and doped region 7 are shown. In this embodiment, wells 5 are formed as parallel strips in the semiconductor body. Only eight wells 5 are shown in FIG. 3 for illustrative purposes. However, MPS diode 1 may include more than eight wells, for example more than 100 wells or even more than 1.000 wells.

In the embodiment shown in FIG. 3, doped region 7 may extend between the space between wells 5. In particular, center region 9a may extend between a first group of wells 5, first outer region 9b may extend between a second group of wells 5, and second outer region 9c may extend between a third group of wells 5. Each of the first group, the second group, and the third group may include a different number of wells 5. In a preferred embodiment, center region 9a includes between 40-60% of the total number of wells 5, more preferably about 50%, and the outer region(s) (e.g., first outer region 9b and second outer region 9c) include a remainder of the total number of wells 5.

A distance between wells 5 of each pair of adjacently arranged wells may be identical, i.e., wells 5 may be equidistantly spaced apart. For example, a first distance d1 between wells in the center region 9a may be equal to a second distance d2 between wells in the first outer region 9b and may be equal to a third distance d3 between wells in the second outer region 9c. A typical spacing between wells 5 may be in a range between 2 - 8 µm, and a typical depth of wells 5 may be about 1 µm, though the present disclosure is not limited thereto.

In another embodiment, a spacing between wells 5 of each pair of adjacently arranged wells depends on a dopant concentration in between said wells 5. In particular, wells 5 of each pair of adjacently arranged wells may be relatively spaced apart such that doped region 7 between said wells becomes depleted at substantially a same voltage applied to MPS diode 1. In other words, the spacing between wells 5 may be selected such that pinch-off of the Schottky current occurs at substantially a same voltage applied to MPS diode 1.

In particular, when the dopant concentration is lower, the extent to which the depletion region of PN junctions changes as a function of the voltage is greater. To that end, since the dopant concentration of second outer region 9c is less than the dopant concentration of first outer region 9b, third distance d3 may be greater than second distance d2. Similarly, since the dopant concentration of first outer region 9b is less than the dopant concentration of center region 9a, second distance d2 may be greater than first distance d1.

Although a border between regions 9a-9c of doped region 7 are shown as coinciding with wells 5, the present disclosure is not limited thereto. Said border(s) could also be positioned in a space between wells 5.

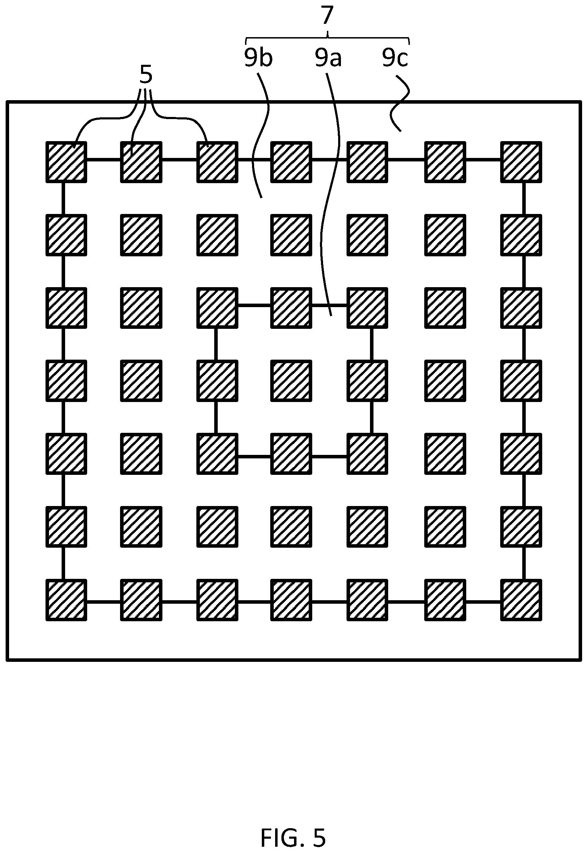

In FIG. 4 and FIG. 5, simplified partial top views of MPS diode 1 of FIG. 2A in accordance with embodiments of the present disclosure are shown. Again, for convenience, only wells 5 and doped region 7 are shown.

As shown in FIG. 4, for example, wells 5 may be formed as concentric shapes. For example, rectangular shapes such as those shown in FIG. 4 can be employed. However, any concentric shape, such as any other polygonal shape or an elliptical (e.g., circular) shape may be used.

FIG. 5 illustrates yet another alternative configuration of wells 5. Instead of strips or concentric shapes, wells 5 may be formed as islands and may be distributed two-dimensionally.

The present disclosure envisages further configurations other than those shown in FIGs. 3-5 and is not limited to any particular configuration of wells 5.

A manufacturing method for MPS diode 1 may be as follows. First, a semiconductor body is provided, for example substrate 2 on which epitaxial layer 3 is grown. Epitaxial layer 3 may comprise or define drift region 4 of the first conductivity type. The semiconductor body includes a portion that will form the active area and a portion that will form the termination area. Doped region 7 may be implanted in the active area, in particular epitaxial layer 3, using one or more mask layers as described above, the mask layer being patterned to form a desired shape and position of doped region 7. After the implantation step(s), said mask layer can be removed again. Wells 5 may be provided via another implantation step using another patterned mask layer defining a desired shape and position of wells 5, and the another patterned mask layer may be removed again after the another implantation step. After that, the metal layer assembly can be arranged on top of the semiconductor body. Contact 8 may be provided with the semiconductor body or arranged subsequently to any of the above described steps. The method may also include, prior to arranging the metal layer assembly, forming termination region 11 via an yet another implantation step using yet another patterned mask layer defining a desired shape and position of termination region 11, as well as arranging insulating layer 10 on top of part of the semiconductor body for electrically insulating the metal layer assembly from the termination area.

Further steps may be included, such as providing a buffer layer between substrate 2 and epitaxial layer 3, providing passivation layers covering part of the metal layer assembly, or the like, as will be appreciated by the skilled person.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A merged PiN Schottky, 'MPS', diode, comprising:
a semiconductor body including an active area, wherein the active area comprises:
a drift region of a first conductivity type; and
a plurality of wells of a second conductivity type different from the first conductivity type, the plurality of wells being mutually spaced apart, each well forming a respective PN-junction with the drift region; and
a metal layer assembly arranged on a surface of the semiconductor body and comprising at least one metal layer, the metal layer assembly forming a plurality of Schottky contacts together with the drift region and a plurality of respective Ohmic contacts with the plurality of wells,
wherein the drift region comprises a doped region surrounding each of the plurality of wells, the doped region having a higher dopant concentration than a remainder of the drift region, wherein, in a first direction from a center of the doped region to an edge of the doped region, the dopant concentration in the doped region decreases.

2. The MPS diode according to claim 1, wherein the doped region comprises a substantially uniformly doped center region and a substantially uniformly doped outer region arranged in between the center region and the edge of the doped region, the center region having a higher dopant concentration than the outer region.

3. The MPS diode according to claim 2, wherein the doped region comprises a plurality of said outer regions, and wherein outer regions arranged closer to the center region have a higher dopant concentration than outer regions arranged further from the center region.

4. The MPS diode according to claim 3, wherein the plurality of outer regions have a substantially identical width in the first direction.

5. The MPS diode according to any of the claims 2-4, wherein the center region surrounds between 40-60% of the number of wells, preferably 50%, wherein the outer region(s) surround a remainder of the number of wells.

6. The MPS diode according to any of the claims 2-5, wherein a dopant concentration in the center region is at least two times higher than a dopant concentration at or near the edge of the doped region, preferably at least three times higher.

7. The MPS diode according to any of the previous claims, wherein a dopant concentration in the doped region is at least two times greater than a dopant concentration in a remainder of the drift region.

8. The MPS diode according to any of the previous claims, wherein the doped region and the plurality of wells each extend from the surface of the semiconductor body, and wherein the doped region extends further into the semiconductor body than the plurality of wells, preferably at least 10% further, more preferably at least 20% further.

9. The MPS diode according to any of the previous claims, wherein the plurality of wells are arranged as parallel strips or as concentric shapes, such as elliptical or polygonal shapes.

10. The MPS diode according to any of the previous claims, wherein a spacing between adjacently arranged wells among the plurality of wells is substantially identical.

11. The MPS diode according to any of the claims 1-9, wherein the wells of each pair of adjacently arranged wells is relatively spaced apart such that the doped region between said wells becomes depleted at substantially a same voltage applied to the MPS diode.

12. The MPS diode according to claim 11, wherein the wells of each pair of adjacently arranged wells have a spacing that increases from the center of the doped region to the edge of the doped region, in accordance with the dopant concentration of the doped region in between said wells.

13. The MPS diode according to any of the previous claims, wherein the semiconductor body further comprises a termination area arranged adjacent to the active area, and/or
wherein the semiconductor body comprises a substrate and an epitaxial layer arranged on said substrate, wherein the active area and, if applicable, the termination area are arranged in the epitaxial layer, wherein the metal layer assembly preferably forms a first terminal of the MPS diode, and wherein the MPS diode preferably further comprises a contact arranged on the substrate, said contact forming a second terminal of the MPS diode.

14. The MPS diode according to any of the previous claims, each of the plurality of wells further comprising a subregion having a higher dopant concentration than a remainder of said well for enabling an Ohmic contact with the metal layer assembly.

15. A method for manufacturing a merged PiN Schottky, 'MPS', diode, comprising:
providing a semiconductor body comprising a drift region of a first conductivity type;
forming a doped region in the drift region, said doped region having a higher dopant concentration than a remainder of the drift region, wherein, in a first direction from a center of the doped region to an edge of the doped region, the dopant concentration in the doped region decreases;
forming a plurality of wells of a second conductivity type different from the first conductivity type in the doped region, the plurality of wells being mutually spaced apart, each well forming a respective PN-junction with the drift region; and
arranging a metal layer assembly on a surface of the semiconductor body, said metal layer assembly comprising at least one metal layer, wherein said metal layer assembly forms a plurality of Schottky contacts together with the drift region and a plurality of respective Ohmic contacts with the plurality of wells,
wherein the drift region comprises a doped region surrounding each of the plurality of wells, the doped region having a higher dopant concentration than a remainder of the drift region, wherein, in a first direction from a center of the doped region to an edge of the doped region, the dopant concentration in the doped region decreases.
